**Europäisches Patentamt**

**European Patent Office**

**Office européen des brevets**

(11) Publication number: **0 067 636**
**B1**

(12) **EUROPEAN PATENT SPECIFICATION**

(45) Date of publication of patent specification: **26.08.87**

(21) Application number: **82302918.6**

(22) Date of filing: **07.06.82**

(51) Int. Cl.⁴: **H 02 B 1/02**

(54) **Support structures for electrical or electronic apparatus.**

(30) Priority: **09.06.81 GB 8117627**

(43) Date of publication of application:
**22.12.82 Bulletin 82/51**

(45) Publication of the grant of the patent:
**26.08.87 Bulletin 87/35**

(84) Designated Contracting States:
**BE CH DE FR IT LI NL SE**

(56) References cited:
**DE-A-1 665 853**
**FR-A-2 117 824**
**US-A-4 127 196**

(73) Proprietor: **The General Electric Company, p.l.c.**
**1 Stanhope Gate**
**London W1A 1EH (GB)**

(72) Inventor: **Breeze, Gerald David**
**7 Drybrook Close**
**Balsall Common West Midlands, CV7 7PY (GB)**
Inventor: **Elliott, Donald Charles**
**20 Spinney Hill**
**Warwick, CV34 5SF (GB)**

(74) Representative: **Dolwin, John Davison et al**
**Central Patent Department Wembley Office The**
**General Electric Company, p.l.c. Hirst Research**
**Centre East Lane**
**Wembley Middlesex HA9 7PP (GB)**

Courier Press, Leamington Spa, England.

## Description

The present invention relates to assemblies of electrical or electronic apparatus.

Rack structures on which apparatus is assembled conventionally take the form of a pair of side pillars or side walls between which are supported a number of shelves one above another, the shelves either carrying apparatus forming complete functional units or acting as supports for smaller units, such as individual printed circuit boards. Rack structures of this kind have conventionally been manufactured in standard heights, widths and depths, with standard vertical intervals between shelves.

Different structures for mounting electrical apparatus are disclosed in FR—A—2117824 and DE—A—1665853.

Design progress in such apparatus as used in, say, telephone exchanges offers increasing facilities with decreasing volume, the volume required to house any particular functional unit being reduced with each successive generation. The inflexibility inherent in rack dimensions chosen for earlier generations of apparatus eventually imposes unacceptable constraints on the disposition of later, more compact, functional units.

According to one aspect of the present invention an assembly of electrical or electronic apparatus comprising a substantially planar support member having therein over at least part of its area a regular array of apertures, means to mount said support member in a substantially vertical plane, and a plurality of component units of electrical or electronic apparatus, is characterised in that the support member comprises a substantially planar support wall member, and that there are provided housing means in which a plurality of said component units of electrical or electronic apparatus are housed to form at least one functional unit, the component units in said housing means being detachably electrically interconnected by means of respective plug and socket type connectors respective parts of which are secured to said housing means and to said component units, hook means extending from said housing means and cooperating with apertures of said array of apertures to mount said functional unit on one side of said support wall member at substantially any required position, means cooperating with other apertures of said array of apertures to mount a plurality of other units of said electrical or electronic apparatus on said one side of said support wall member, and means electrically to interconnect the units of apparatus mounted on said support wall member.

According to another aspect of the present invention as assembly of electrical or electronic apparatus comprising a substantially planar support member having therein over at least part of its area a regular array of apertures, a support structure for mounting said support member in a substantially vertical plane, and a plurality of component units of electrical or electronic apparatus, is characterised in that the support structure comprises at least two vertically extending column members and means supporting said column members to lie in a common plane, and that there are two of said planar support members each in the form of planar support wall members secured one on either side of said column members and parallel to said common plane such that said support wall members are spaced from one another by said column members, and there are provided housing means in which a plurality of said component units are housed to form at least one functional unit, the component units in said housing means being detachably electrically interconnected by means of respective plug and socket type connectors respective parts of which are secured to said housing means and to said component units, hook means extending from said housing means and cooperating with apertures of said array of apertures to mount said functional unit on the outer side of one of said support wall members at substantially any required position, means cooperating with other apertures of said array of apertures to mount a plurality of other units of said electrical or electronic apparatus on said support wall members, and means electrically to interconnect the units of apparatus mounted on said support wall members.

Each support wall member may comprise a planar sheet of mild steel or stainless steel having a regular array of rectangular apertures over substantially the whole of its area. Alternatively each support wall member may comprise an orthogonal mesh of steel rods or wires the crossing points of which are welded.

The means carrying a unit of said apparatus may comprise a substantially rectangular open-fronted box the side walls of which are provided with rearwardly extending hook means by which the unit is attached to the support wall member. Preferably these hook means are arranged to hold the rear face of the box parallel to but spaced from the surface of the support wall member. Alternatively the means carrying a unit of said apparatus may comprise a substantially planar carrier which is arranged to be attached to the wall member so as to lie generally parallel to but spaced from the surface of the wall member.

An assembly of electrical or electronic apparatus, the assembly comprising a support structure in accordance with the present invention, will now be described with reference to the accompanying drawings, of which:—

Figure 1 shows schematically a suite of apparatus, Figures 2 and 3 show respective vertical and horizontal part-sectional views of parts of the apparatus shown in Figure 1,

Figure 4 shows a part of the apparatus of Figure 1 in greater detail, and

Figure 5 shows another part of the apparatus in greater detail.

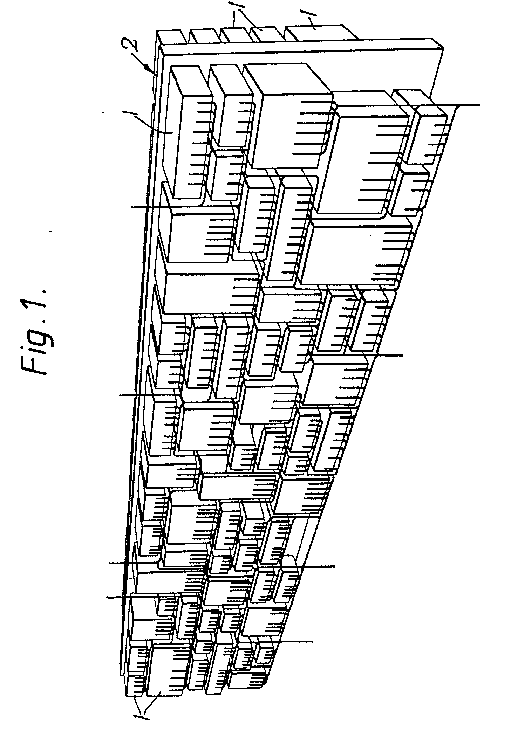

Referring first to Figure 1 individual functional units 1 of a suite of apparatus are arranged to be attached on either side to a double-side support wall 2, with the interconnections between the units 1, and the external connections to the apparatus, being provided at the front faces of the units 1, that is, at the faces remote from the support wall 2. These interconnections and external connections may be made by way of modular plug and socket connectors (not shown), including for example coaxial cable connectors, optical fibre couplings, power input connectors and multi-pin connectors having, say, 2.5 millimetre pin spacing in a 7 by 3 matrix. The multi-pin connectors may be compatible with reverse DIN connectors (not shown) provided at the rear of a unit 1 for connections between individual circuit boards of the unit 1.

A unit 1 may be of a height to house standard single or double height "Euro-card" printed circuit boards, and of virtually any reasonable width to accommodate the required number of circuit boards.

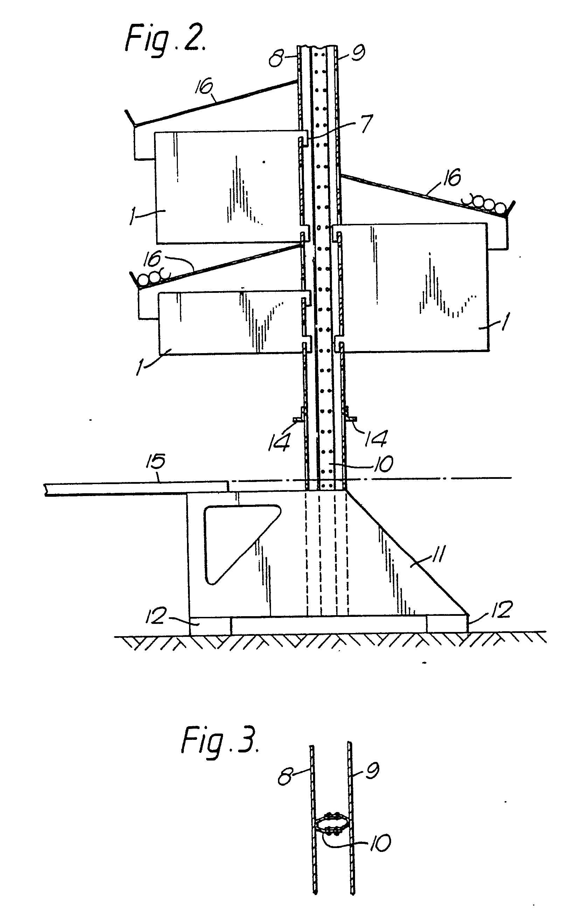

Referring also to Figures 2 to 4 each unit 1 comprises effectively an open-fronted box having generally planar upper and lower faces 3 and 4, which carry guides (not shown) for the printed circuit boards (not shown) and which may be pierced for ventilation purposes, and end faces 5 and 6 which are provided with rearwardly extending lugs 7 by which the unit is attached to the support wall 2.

The rear face of the unit 1, adjacent the support wall 2, may either comprise simply a set of plug and socket connectors (not shown), supported by the faces 3 to 6, for interconnecting the individual printed circuit boards, or may comprise a back plane member. This back plane member, which may be of metal but is preferably of an electrically insulating material such as resin-impregnated glass-fibre board, in turn may support the required plug and socket connectors. In the case of an insulating board it may also carry "printed" wiring for interconnecting the plug and socket connectors.

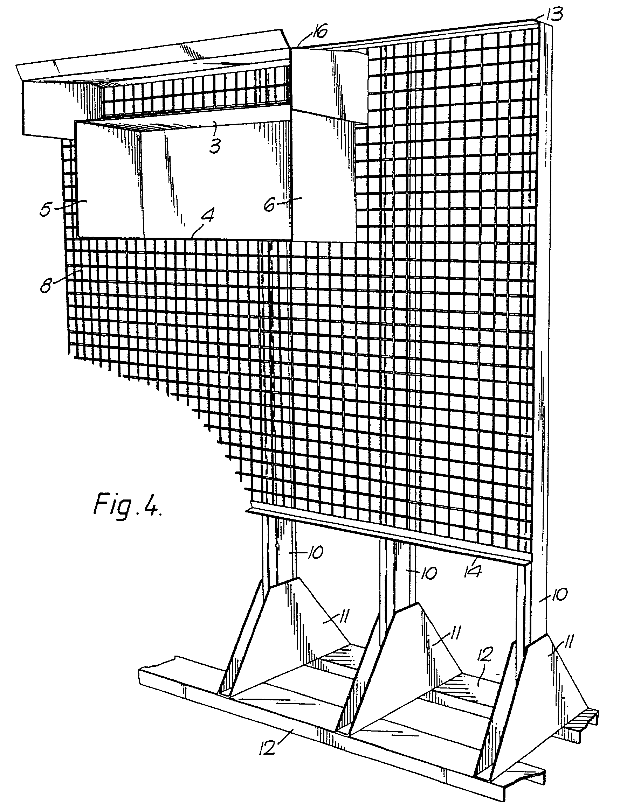

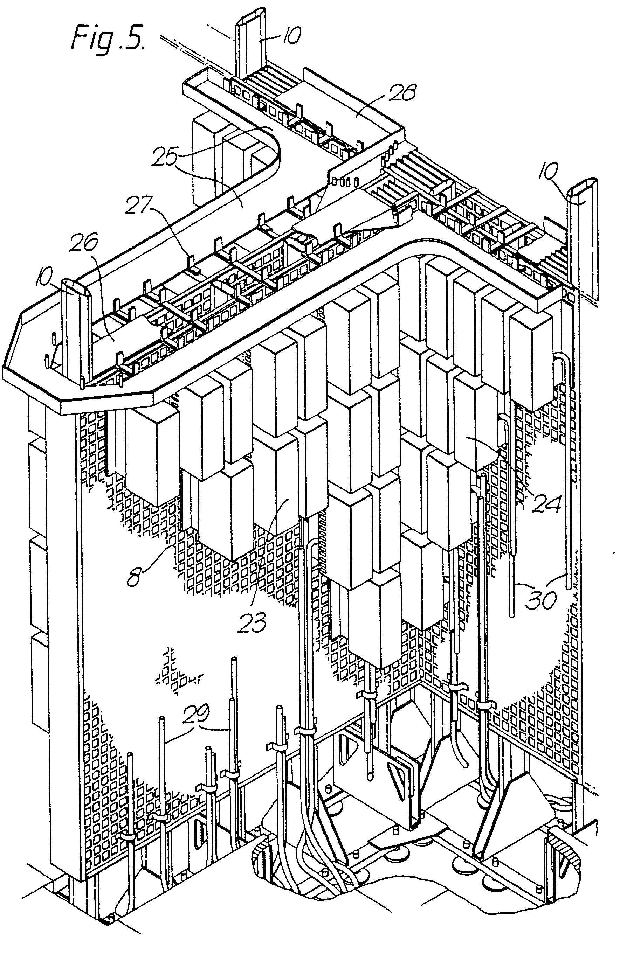

The support wall 2 comprises two substantially planar members 8 and 9 which are secured, for example by rivetting, to vertical columns 10. The members 8 and 9 may be of mild steel or stainless steel sheet having a regular array of square holes punched therein, as shown in Figure 5, these holes being at approximately 3 centimetres pitch. Alternatively the members 8 and 9 may be formed as orthogonal arrays of mild steel rods or wires at approximately 3 centimetres pitch, the rods or wires being welded together at their crossing points, as shown in Figure 4.

As shown in Figure 3 each of the columns 10 is fabricated from two channel sections rivetted together to provide a hollow, flattened octagonal section, the narrow faces of this octagonal section column being rivetted to the punched-sheet wall members 8 and 9 and the broader faces being rivetted to generally triangular base supports 11. These supports 11 in turn are secured to inverted channel-section members 12 which run longitudinally to interconnect the support members 11 of all the columns 10 in the wall 2. The longitudinal members 12 may be provided with levelling bolts (not shown) and with means (not shown) to secure the structure to the floor.

The upper and lower edges of the wall members 8 and 9 may be stiffened by horizontal angle members 13 and 14.

The floor 15 may either be supported independently of the apparatus supporting structure or may rest on beams (not shown) secured to the base supports 11.

The lugs 7 on the end faces 5 and 6 of the units 1 are arranged to hook over the lower edges of respective holes in the wall members 8 and 9, and it will be appreciated that because of the "open-mesh" nature of the wall members 8 and 9 units 1 can be of virtually any width, without restriction to a multiple of a basic unit width.

Above each unit 1, or above a column of units 1, there may be provided an inclined airflow deflector 16 by means of which rising air warmed by heat dissipation within the units 1 may be deflected through the holes in the respective wall member 8 or 9 into the space between the wall members 8 and 9. This space may act as a chimney for the rising air. If necessary some of the holes in the wall members 8 and 9 may be blanked off to increase the effectiveness of the chimney.

Forced ventilation may be provided for individual units 1 by providing ventilating fans within or associated with these units 1, or an extractor fan may be provided (not shown) at the top of the chimney. If greater heat dissipation is to be met inlet and extractor fans may be provided, or cool air from a service unit may be ducted to individual areas within the units 1 and extracted by way of the deflectors 16 and the chimney.

If the ambient temperature is too high the service unit may include a heat exchanger (not shown).

The outer or front edges 17 of the air deflectors 16 may be bent upwards to act as cable supports for the inter-unit wiring.

Where any particular component or set of components is required to dissipate a considerable amount of heat this component or set of components may be mounted on an individual circuit board (not shown) which is attached to a wall member 8 or 9 so as to lie generally parallel to that wall member.

The smaller functional units 1 of future apparatus will in general not be as deep as existing rack shelves. Where existing shelf-mounted functional units are to be used in conjunction with wall mounted units as described above sections of the members 8 and 9 may be omitted or removed and the shelf-mounted units (not shown) mounted directly between columns 10 so as to project on either side of the wall 2. The columns 10 may be spaced at suitable distances from one another to accommodate existing standard-width shelves, or auxiliary columns or part columns (not shown) may be provided to frame the openings in the wall 2.

Once the suite of apparatus is installed and commissioned the front faces may be covered by sliding or hinged doors (not shown), which may serve the additional purpose of channeling cooling airflow.

It will be appreciated that with the flexibility offered by the apparatus described above the inter-unit cable spacing can be adjusted to meet requirements simply by positioning the units as required on the wall 2, and units can also be positioned to optimise cable runs. Functional units 1 can be subdivided if necessary to avoid high heat concentrations. At the same time a standardised approach may be used to meet the requirements of a large scale installation such as a main exchange.

Since the support wall 2 and the members 11 and 12 support the associated suite of apparatus as a unified assembly the apparatus can be mounted and tested in the factory and then transported to its intended site ready for use.

The welded-wire form of support wall member 8 or 9 may be particularly useful where large numbers of insulated wires would be threaded through the mesh of the wall 2. The rounded surfaces of the wires avoid undesirable insulation cutting or stripping.

The structure described above is to a great extent amendable to production by numerically controlled stamping machines. The wall 2 may be produced in any required size from, say, the order of a metre square upwards.

Referring now in particular to Figure 5 line termination units 23 and exchange termination units 24 may form a major part of a suite of exchange apparatus, particularly as the development of smaller and smaller electronic units 1 proceeds. One or more laterally extending sections of wall, as shown in Figure 5, may therefore be provided to minimise space requirements and to keep inter unit wiring as short as possible.

Trays 25 may be provided to route local wiring or "jumpers" between line and exchange termination units 23 and 24 respectively within the section, while a central tray 26 accommodates wiring running between line termination units 23 to main wiring paths at the rear face of the section (not shown). Turning posts 27 may be provided for wires leaving the cable trays 25 and 26. Trays 28 accommodate non-local wiring from exchange termination units 24 to the main wiring paths (not shown). Line cables 29 and exchange cables 30 may either be routed beneath the flooring 15, as shown in Figure 5, or may be routed by way of overhead trays or mesh (not shown) supported on extended column members 10. The edges of the floor 15 may be supported on generally rectangular supports 31 used in place of some of the supports 11.

**Claims**

1. An assembly of electrical or electronic apparatus comprising a substantially planar support member having therein over at least part of its area a regular array of apertures, means (10, 11, 12) to mount said support member in a substantially vertical plane, and a plurality of component units of electrical or electronic apparatus, characterised in that the support member comprises a substantially planar support wall member (8, 9), and that there are provided housing means (1) in which a plurality of said component units of electrical or electronic apparatus are housed to form at least one functional unit, the component units in said housing means (1) being detachably electrically interconnected by means of respective plug and socket type connectors respective parts of which are secured to said housing means (1) and to said component units, hook means (7) extending from said housing means (1) and cooperating with apertures of said array of apertures to mount said functional unit on one side of said support wall member (8, 9) at substantially any required position, means cooperating with other apertures to mount a plurality of other units of said electrical or electronic apparatus on said one side of said support wall member (8, 9), and means electrically to interconnect the units of apparatus mounted on said support wall member (8, 9).

2. An assembly of electrical or electronic apparatus comprising a substantially planar support member having therein over at least part of its area a regular array of apertures, a support structure (10, 11, 12) for mounting said support member in a substantially vertical plane, and a plurality of component units of electrical or electronic apparatus, characterised in that the support structure comprises at least two vertically extending column members (10) and means (11, 12) supporting said column members (10) to lie in a common plane, and that there are two of said planar support members each in the form of planar support wall members (8, 9) secured one on either side of said column members (10) and parallel to said common plane such that said support wall members (8, 9) are spaced from one another by said column members (10), and there are provided housing means (1) in which a plurality of said component units are housed to form at least one functional unit, the component units in said housing means (1) being detachably electrically interconnected by means of respective plug and socket type connectors respective parts of which are secured to said housing means (1) and to said component units, hook means (7) extending from said housing means (1) and cooperating with apertures of said array of apertures to mount said functional unit on the outer side of one of said support wall members (8, 9) at substantially any required position, means cooperating with other apertures of said array of apertures to mount a plurality of other units of said electrical or electronic apparatus on said support wall members (8, 9), and means electrically to interconnect the units of apparatus mounted on said support wall members (8, 9).

3. An assembly in accordance with Claim 2 characterised in that each support wall member

7     **0 067 636**     8

(8, 9) comprises a planar sheet of steel having therein over substantially the whole of its area a regular array of rectangular apertures.

4. An assembly in accordance with Claim 2 characterised in that each support wall member (8, 9) comprises an orthogonal mesh of steel rods the crossing points of which are welded.

5. An assembly in accordance with any one of Claims 2 to 4 characterised in that said housing means (1) comprises a substantially rectangular open-fronted box the side walls (6) of which are provided with said hook means (7) by which said box is attached to the support wall member (8, 9).

6. An assembly in accordance with Claim 5 characterised in that the hook means (7) are arranged to hold the rear face of the box parallel to but spaced from the surface of the support wall member (8, 9).

7. An assembly in accordance with any one of Claims 2 to 6 characterised in that there is provided means to mount a component unit of said electrical or electronic apparatus on one of said support wall members (8, 9), said means comprising a substantially planar carrier which is arranged to be attached to the respective support wall member (8, 9) so as to lie generally parallel to but spaced from the surface of said support wall member (8, 9).

**Patentansprüche**

1. Elektrische oder elektronische Gerätebaugruppe enthaltend ein im wesentlichen planares Tragteil mit einer darin sich wenigstens über einen Teil seiner Fläche erstreckenden regelmäßigen Anordnung aus Öffnungen, eine Vorrichtung (10, 11, 12) zum Haltern des Tragteils in einer im wesentlichen vertikalen Ebene und eine Vielzahl elektrischer oder elektronischer Geräteteileinheiten, dadurch gekennzeichnet, daß das Tragteil ein im wesentlichen planares Tragwandteil (8, 9) enthält und daß vorgesehen sind eine Gehäuseeinrichtung (1), in der eine Vielzahl der elektrischen oder elektronischen Geräteteileinheiten unter Ausbildung wenigstens einer Funktionseinheit untergebracht ist, wobei die Teileinheiten in der Gehäuseeinrichtung (1) mit Hilfe von jeweiligen steckbuchsenartigen Verbindern lösbar elektrisch verbunden sind und jeweilige Teile der Verbinder an der Gehäuseeinrichtung (1) und an den Teileinheiten angebracht sind, hakenartige Gebilde (7), die sich von der Gehäuseeinrichtung (1) aus erstrecken und zur Halterung der Funktionseinheit auf einer Seite des Tragwandteils (8, 9) bei im wesentlichen irgendeiner erforderlichen Position mit Öffnungen der Öffnungsanordnung zusammenarbeiten, Einrichtungen, die zur Halterung einer Vielzahl von anderen elektrischen oder elektronischen Geräteeinheiten an der einen Seite des Tragwandteils (8, 9) mit anderen Öffnungen der Öffnungsanordnung zusammenarbeiten, und Einrichtungen zur elektrischen Zwischenverbindung der am Tragwandteil (8, 9) gehalterten Geräteeinheiten.

2. Elektrische oder elektronische Gerätebaugruppe enthaltend ein im wesentlichen planares Tragteil mit einer darin sich wenigstens über einen Teil seiner Fläche erstreckenden regelmäßigen Anordnung aus Öffnungen, eine Tragkonstruktion (10, 11, 12) zur Halterung des Tragteils in einer im wesentlichen vertikalen Ebene und eine Vielzahl von elektrischen oder elektronischen Geräteteileinheiten, dadurch gekennzeichnet, daß die Tragkonstruktion wenigstens zwei sich vertikal erstreckende Ständerteile (10) und eine Vorrichtung (11, 12) zum Tragen der Ständerteile (10) in einer gemeinsamen Ebene enthält, daß zwei der planaren Tragteile vorgesehen sind, und zwar jedes in der Form von planaren Tragwandteilen (8, 9), von denen jeweils eines auf jeder Seite der Ständerteile (10) parallel zu der gemeinsamen Ebene derart befestigt ist, daß die Tragwandteile (8, 9) durch die Ständerteile (10) voneinander beabstandet sind, und daß vorgesehen sind eine Gehäuseeinrichtung (1), in der eine Vielzahl der Teileinheiten unter Ausbildung wenigstens einer Funktionseinheit untergebracht ist, wobei die Teileinheiten in der Gehäuseeinrichtung (1) mit Hilfe von jeweiligen steckbuchsenartigen Verbindern lösbar elektrisch verbunden sind und jeweilige Teile der Verbinder an der Gehäuseeinrichtung (1) und an den Teileinheiten angebracht sind, hakenartige Gebilde (7), die sich von der Gehäuseeinrichtung (1) aus erstrecken und zur Halterung der Funktionseinheit an der Außenseite einer der Tragwandteile (8, 9) bei im wesentlichen irgendeiner erforderlichen Position mit Öffnungen der Öffnungsanordnung zusammenarbeiten, Einrichtungen, die zur Halterung einer Vielzahl von anderen Einheiten des elektrischen oder elektronischen Geräts an den Stützwandteilen (8, 9) mit anderen Öffnungen der Öffnungsanordnung zusammenerarbeiten, und Einrichtungen zur elektrischen Zwischenverbindung der an den Tragwandteilen (8, 9) gehalterten Geräteeinheiten.

3. Baugruppe nach Anspruch 2, dadurch gekennzeichnet, daß jedes Tragwandteil (8, 9) ein planares Blech aus Stahlt enthält, in welchem eine sich im wesentlichen über seinen gesamten Bereich erstreckende regelmäßige Anordnung aus rechteckförmigen Öffnungen vorgesehen ist.

4. Baugruppe nach Anspruch 2, dadurch gekennzeichnet, daß jedes Tragwandteil (8, 9) ein orthogonales Gitter aus Stahlstäben enthält, deren Überkreuzungsstellen verschweißt sind.

5. Baugruppe nach einem der Ansprüche 2 bis 4, dadurch gekennzeichnet, daß die Gehäuseeinrichtung (1) einen im wesentlichen rechteckförmigen, an seiner Vorderseite offenen Kasten enthält, an dessen Seitenwände (6) die hakenartigen Gebilde (7) vorgesehen sind, mit denen der Kasten an dem Tragwandteil (8, 9) angebracht ist.

6. Baugruppe nach Anspruch 5, dadurch gekennzeichnet, daß die hakenartigen Gebilde (7) derart angeordnet sind, daß sie die Rückseite des Kastens parallel zur Oberfläche des Tragwandteils (8, 9), jedoch in einem Abstand von dieser Oberfläche halten.

5

7. Baugruppe nach einem der Ansprüche 2 bis 6, dadurch gekennzeichnet, daß eine Vorrichtung zur Halterung einer Teileinheit des elektrischen oder elektronischen Geräts an einer der Tragwandteile (8, 9) vorgesehen ist und diese Vorrichtung einen im wesentlichen planaren Träger aufweist, der derart angeordnet ist, daß er an dem betreffenden Tragwandteil (8, 9) in einer solchen Weise anbringbar ist, daß er im allgemeinen parallel zur Oberfläche dieses Tragwandteils (8, 9) verläuft, jedoch von dieser Oberfläche beabstandet ist.

**Revendications**

1. Ensemble d'appareils électriques ou électroniques, comprenant un organe sensiblement plan de support ayant, sur une partie au moins de son étendue, un arrangement régulier d'ouvertures, un dispositif (10, 11, 12) de montage de l'organe de support dans un plan sensiblement vertical, et plusieurs éléments constituants d'appareil électrique ou électronique, caractérisé en ce que l'organe de support est un organe sensiblement plan de paroi de support (8, 9) et en ce qu'il comporte un dispositif formant boîtier (1) dans lequel plusieurs éléments constituants d'appareil électrique ou électronique sont logés afin qu'ils forment au moins un élément fonctionnel, les éléments constituants placés dans le dispositif (1) formant boîtier étant interconnectés électriquement temporairement par des connecteurs respectifs du type mâle-femelle dont des parties sont fixées au dispositif (1) formant boîtier et aux éléments constituants, un dispositif (7) d'accrochage dépassant du dispositif (1) formant boîtier et coopérant avec des ouvertures de l'arrangement d'ouvertures afin que l'élément fonctionnel soit monté sur une face de l'organe (8, 9) formant paroi de support pratiquement en toutes positions voulues, un dispositif coopérant avec d'autres ouvertures de l'arrangement d'ouvertures afin que plusieurs autres éléments d'appareil électrique ou électronique soient montés sur ladite face de l'organe formant paroi de support (8, 9), et un dispositif assurant l'interconnexion électrique des éléments d'appareil montés sur l'organe formant paroi de support (8, 9).

2. Ensemble d'appareils électriques ou électroniques comprenant un organe sensiblement plan de support ayant sur une partie au moins de sa surface un arrangement régulier d'ouvertures, une structure de support (10, 11, 12) destinée au montage de l'organe de support dans un plan sensiblement vertical, et plusieurs éléments constituants d'appareil électrique ou électronique, caractérisé en ce que la structure de support comporte au moins deux organes verticaux (10) formant colonnes et un dispositif (11, 12) de support des organes (10) formant colonnes afin que ceux-ci se trouvent dans un plan commun, et il comporte deux organes plans de support chacun sous forme d'organes (8, 9) de paroi plane de support fixés de part et d'autre des organes (10) en forme de colonnes et parallèlement au plan commun de manière que les organes de paroi de support (8, 9) soient séparés mutuellement par les organes de colonnes (10), et il comporte un dispositif formant boîtier (1) dans lequel sont logés plusieurs éléments constituants destinés à former au moins un élément fonctionnel, les éléments constituants placés dans le dispositif formant boîtier (1) étant interconnectés électriquement de façon temporaire par des connecteurs respectifs du type mâle-femelle dont des parties respectives sont fixées au dispositif formant boîtier (1) et aux éléments constituants, un dispositif d'accrochage (7) dépassant du dispositif (1) formant boîtier et coopérant avec des ouvertures de l'arrangement d'ouvertures afin que l'élément fonctionnel soit monté à la face externe de l'un des organes de paroi de support (8, 9) pratiquement en toute position voulue, un dispositif coopérant avec d'autres ouvertures de l'arrangement d'ouvertures afin que plusieurs autres éléments d'appareil électrique ou électronique soient montés sur les organes de paroi de support (8, 9), et un dispositif assurant l'interconnexion électrique des éléments d'appareil montés sur les organes formant paroi de support (8, 9).

3. Ensemble selon la revendication 2, caractérisé en ce que chaque organe de paroi de support (8, 9) est une tôle plane d'acier ayant sur pratiquement sur toute sa surface un arrangement régulier d'ouverture rectangulaire.

4. Ensemble selon la revendication 2, caractérisé en ce que chaque organe de paroi de support (8, 9) est une grille orthogonale de tiges d'acier dont les points de croisement sont soudés.

5. Ensemble selon l'une quelconque des revendications 2 à 4, caractérisé en ce que le dispositif formant boîtier (1) a une boîte sensiblement rectangulaire dont l'avant est ouvert, ces parois latérales (6) ayant des dispositifs d'accrochage (7) permettant la fixation de la boîte à l'organe formant paroi de support (8, 9).

6. Ensemble selon la revendication 5, caractérisé en ce que le dispositif d'accrochage (7) est destiné à maintenir la face arrière de la boîte parallèlement à la surface de l'organe formant paroi de support (8, 9), mais à distance de cette paroi.

7. Ensemble selon l'une quelconque des revendications 2 à 6, caractérisé en ce qu'il comporte un dispositif de montage d'un élément constituant d'appareil électrique ou électronique sur l'un des organes formant paroi de support (8, 9), le dispositif comprenant un support sensiblement plan qui est destiné à être fixé à l'organe respectif de paroi de support (8, 9) afin qu'il soit sensiblement parallèle à la surface de l'organe formant paroi de support (8, 9) mais à distance de cette surface.

Fig.1.

0 067 636

Fig .2.

Fig .3.

Fig.4.

Fig.5.